# FASCICULE DE BREVET EUROPEEN

(11) **EP 0 542 652 B1**
(45) Date de publication et mention de la délivrance du brevet: **10.04.1996**
(21) Numéro de dépôt: 92420413.4
(22) Date de dépôt: 13.11.1992
(51) Int. Cl.: H01R 9/09, H01R 13/115

(54) **Contact connecteur pour circuits hybrides utilisés en micro-électronique assurant une liaison entre un substrat et un support**
Steckverbinderkontakt für hybride Stromkreise der Mikroelektronik zur Verbindung eines Substrates zum Träger
Connector contact for hybrid circuits used in microelectronics for connecting a substrate to a support

(30) Priorité: 15.11.1991 FR 9114517
(43) Date de publication de la demande: 19.05.1993
(73) Titulaire: POSSEHL ELECTRONIC FRANCE S.A., F-42230 Roche La Molière (FR)
(72) Inventeur: Grawehl, Dieter, Hamburg (DE)
(74) Mandataire: Dupuis, François

(56) Documents cités:
- EP-A- 0 208 500
- FR-A- 2 586 158
- US-A- 4 598 972

## Description

Plus particulièrement, l'invention concerne la microélectronique.

Il est connu d'employer notamment en micro-électronique, des substrats en céramique ou autres, sur lesquels sont montés des composants électroniques constituant des micro circuits hybrides pour remplir une fonction spécifique. Ces substrats doivent être connectés à un support, tel qu'un circuit imprimé, pour les alimenter électriquement et recevoir les signaux attendus.

Généralement, cette liaison électrique s'effectue au moyen de contacts connus sous le nom de connecteurs hybrides et conformés pour assurer une liaison efficace et de mise en oeuvre aisée. Le plus souvent, ces contacts font partie d'un ensemble présentant une bande de maintien supérieure et une bande de maintien inférieure, en y étant reliés par tout type d'agencement permettant de les détacher facilement.

La partie supérieure de ces contacts est conformée pour être reliée au substrat. Notamment, cette partie supérieure est convenablement découpée pour constituer une pince apte à enserrer, par élasticité, le bord du substrat au niveau des points de contact électriques. Les jonctions sont ensuite rendues définitives, notamment par une opération de soudure à l'étain. Les contacts sont alors détachés de la bande inférieure.

Il convient ensuite d'assurer la liaison entre le substrat et le support au moyen des contacts. Or, cette liaison pose des problèmes. En effet, les différents composants électroniques répartis sur le substrat tendent à l'alourdir, provoquant ainsi un défaut de stabilité verticale du substrat après engagement des contacts dans le support.

Pour remédier à cet inconvénient, il est possible d'intervenir manuellement pour rétablir la stabilité verticale. Par contre, une telle intervention manuelle s'avère à ce jour incomptatible avec les techniques employées, faisant appel à un automatisme avancé.

Une telle instabilité rend la soudure des contacts dans leur logement, très aléatoire et parfois inefficace.

Un tel contact est connu par le document US-A-4598972 qui montre les caractéristiques du préambule de la revendication 1.

Pour résoudre un tel problème, on a proposé certaines solutions au niveau notamment de la partie du contact devant être introduite dans les logements correspondants du support. Par exemple, à titre indicatif nullement limitatif, on a proposé de replier, sous la forme d'un V, la base du contact. Cette solution s'avère difficile à obtenir techniquement et ne résoud pas d'une manière correcte, le problème de la stabilité.

On a également proposé l'extrusion d'une lamelle au niveau de la base du contact, ou un dédoublement du contact par cisaillage dans l'axe médian de la largeur dudit contact et pliage avec repoussage. Là encore, l'une ou l'autre de ces deux solutions ne donne pas satisfaction, la liaison électrique obtenue n'est pas parfaite et le substrat ne se trouve pas maintenu dans un plan rigoureusement perpendiculaire au support.

On connait également le brevet EP 0208500 qui divulgue un connecteur d'une application différente de celle visée dans la demande étant donné que le connecteur divulgué dans ce brevet est du type " pressfit". Il s'agit donc d'un connecteur mobile destiné à être connecté et déconnecté un nombre de fois important, ce qui n'est pas le cas avec un contact connecteur destiné à assurer une liaison entre un substrat et un support. En faisant abstraction de cette application différente, ce brevet montre une section de connexion obtenue par poinçonnage à partir d'un fil de section ronde. Il en résulte un élasticité très faible.

L'invention s'est fixée pour but de remédier à ces inconvénients, de manière simple, sûre, efficace et rationnelle.

Le problème que se propose de résoudre l'invention est d'obtenir une parfaite stabilité du substrat par rapport au support, après connexion au moyen des contacts, tout en ayant pour objectif une très bonne connexion électrique au niveau de la partie du contact destinée à être engagée dans un trou du support. Par ailleurs, le probème que se propose de résoudre l'invention est d'obtenir une section apte à épouser par élasticité la section du trou du support.

Pour résoudre ces problèmes la partie des contacts destinée à être engagée dans le trou du support constitue un flan séparé partiellement de la partie destinée à être fixée sur le substrat par des découpes prenant naissance sur ses bords latéraux et réalisées par une opération de prédécoupage suivie d'un roulage apte à lui conférer une section transversale ouverte profilée, pour épouser par élasticité, la section du trou du support.

Avantageusement, compte-tenu du problème posé à résoudre, après roulage, le flan a une section profilée, très sensiblement en forme de C.

D'une manière connue, le contact fait partie d'un ensemble présentant une bande de maintien supérieure et une bande de maintien inférieure auxquelles est reliée une pluralité de contacts.

Selon l'invention, le flan de chacun des contacts est relié par un chanfrein prolongé par une bande rectiligne de plus faible largeur, à la bande de maintien inférieure.

L'invention est exposée, ci-après plus en détail à l'aide des dessins annexés, dans lesquels :

La figure 1 est une vue de face montrant les contacts selon l'invention, reliés à des bandes de maintien supérieure et inférieure, les contacts étant représentes avant l'opération de prédécoupage et de roulage du flan.

La figure 2 est une vue transversale considérée selon la ligne 2-2 de la figure 1.

La figure 3 est une vue de face montrant la liaison entre un substrat et un support au moyen des contacts selon l'invention.

La figure 4 est une vue en coupe transversale considérée selon la ligne 4-4 de la figure 3.

La figure 5 est une vue en plan et en coupe considérée selon la ligne 5-5 de la figure 3.

D'une manière connue, le contact désigné dans son ensemble par (1), présente une partie (A) destinée à être fixée sur le substrat (S) et une partie (B) destinée à être engagée et connectée dans un trou (C1) du support (C). A noter que le substrat (S) et le support (C) ne sont pas décrits en détail car ils sont parfaitement connus pour un homme du métier et peuvent présenter différentes formes de réalisation.

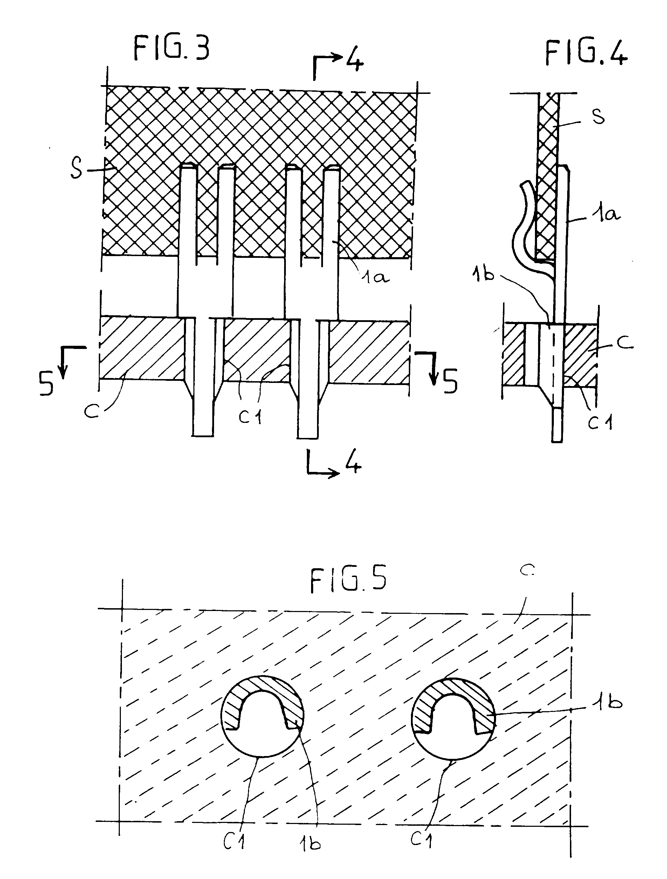

De même, la partie (A) présente tout type d'agencement pour sa fixation et sa connexion sur le substrat (S). Par exemple, et comme le montrent les figures 3 et 4, cette partie (A) est convenablement découpée pour constituer une pince (1a) pour enserrer le bord du substrat au niveau des points de contact.

Selon une caractéristique à la base de l'invention, la partie (B) constitue un flan (1b) formé dans le prolongement de la pince (1a). Ce flan (1b) est soumis à un traitement apte à lui conférer une section transversale ouverte et profilée pour épouser par élasticité, la section du trou (C1). Ce traitement est constitué par un prédécoupage du flan à une hauteur déterminée, suivie d'un roulage de ce dernier. Avantageusement, la section obtenue est profilée très sensiblement en forme de C largement ouvert afin de s'adapter parfaitement par élasticité dans la section du trou (C1) du support (C) (figure 5).

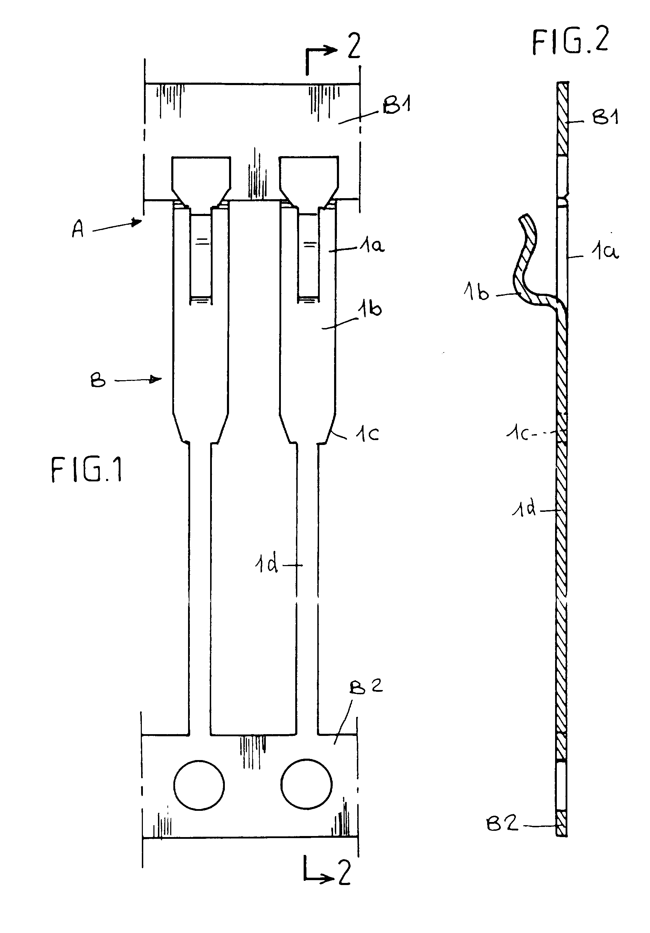

Comme le montrent les figures 1 et 2, le contact (1) fait, d'une manière connue, partie d'un ensemble présentant une bande de maintien supérieure (B1) et une bande de maintien inférieure (B2). Le flan (1b) de chacun des contacts (1) est relié par un chanfrein (1c) prolongé par une bande rectiligne (1d) de plus faible largeur à la bande de maintien inférieure (B2).

Selon l'invention, le flan (1b) des différents contacts est maintenu à plat pendant la durée des opérations nécessaires à l'assemblage desdits contacts sur le substrat (S) par les parties (1a) formant pince, puis soudage de ces dernières. En phase finale, et avant de procéder à l'engagement du flan (1b) dans les ouvertures correspondantes (C1) du support (C), ce dernier est soumis à l'opération de prédécoupage et de roulage. A noter que cette opération s'effectue par l'utilisation d'un outillage adapté permettant d'obtenir des ajustements en fonction des diamètres du trou récepteur (C1) et de la hauteur souhaitée (h) entre la base du substrat et la surface du support (C).

Les avantages ressortent bien de la description, en particulier on souligne et on rappelle:
- La stabilité verticale obtenue conférant une bonne qualité au niveau de la liaison électrique.
- La facilité d'introduction du flan après prédécoupage et mise en forme, compte-tenu notamment du chanfrein qui constitue une portée conique.
- l'élasticité résultant de l'opération de prédécoupage suivie d'un roulage de la partie de contact sous forme d'un flan.

## Revendications

1. Contact connecteur pour circuits hybrides utilisés en microélectronique assurant une liaison entre un substrat et un support (c), ledit contact présentant une première partie (A) destinée à être fixée sur le substrat (S), et une seconde partie (B) destinée à être engagée notamment dans un trou (C1) du support (C), caractérisé en ce que la seconde partie (B) constitue un flan (1b) séparé partiellement de la première partie (A) par des découpes prenant naissance sur ses bords latéraux et réalisées par prédécoupage, cette seconde partie (B) ayant une section transversale ouverte profilée obtenue par roulage, apte à épouser par élasticité la section du trou (C1) du support (C).

2. Contact selon la revendication 1, caractérisé en ce que le flan (1b) a une section profilée très sensiblement en forme de C, obtenue par roulage.

3. Ensemble comportant des contacts selon la revendication 1 ou 2, caractérisé en ce qu'il comprend une bande de maintien supérieure (B1) à laquelle est reliée une pluralité de contacts par leurs premières parties respectives (A), et une bande de maintien inférieure (B2), le flan (1b) de chacun des contacts étant relié à la bande de maintien inférieure par un chanfrein (1c) prolongé par une bande rectiligne (1d) de plus faible largeur.

## Patentansprüche

1. Steckkontakt für in der Mikroeloktronik verwendete Hybrid-Schaltkreise zur Gewährleistung einer Verbindung zwischen einem Substrat und einem Träger (C), wobei der Kontakt einen ersten Teil (A) zur Befestigung auf dem Substrat (S) und einen zweiten Teil (B) zur Einführung insbesondere in eine Bohrung (C1) des Trägers (C) aufweist, dadurch gekennzeichnet, daß das zweite Teil (B) einen Nutzen (1b) bildet, der durch Schnitte, die von den seitlichen Rändern ausgehen und durch Vorschneiden erzeugt werden, teilweise vom ersten Teil (A) getrennt ist, wobei der zweite Teil (B) einen durch Rollen erzielten offenen profilierten Querschnitt besitzt, der geeignet ist, sich elastisch an den Querschnitt der Bohrung (C1) des Trägers (C) anzupassen.

2. Kontakt nach Anspruch 1, dadurch gekennzeichnet, daß der Nutzen (1b) einen ziemlich genau C-förmigen, durch Rollen erzieltem profilierten Querschnitt besitzt.

3. Baugruppe mit Kontakten nach Anspruch 1 oder 2, dadurch gekennzeichnet, daß sie ein oberes Halteband (B1) aufweist, mit dem eine Vielzahl von Kontakten durch die jeweiligen ersten Teile (A) verbunden sind, und ein unteres Halteband (B2), wobei der Nutzen (1b) jedes einzelnen Kontakts über eine Fase (1c), die durch einen geradlinigen Streifen (1d) geringerer Breite verlängert wird, mit dem unteren Halteband verbunden ist.

## Claims

1. Connector contact for hybrid circuits used in microelectronics providing a connection between a substrate and a support (C), said contact having a first part (A) designed to be attached to the substrate (S) and a second part (B) designed to fit in a hole (C1) in particular, in the support (C), characterised in that, the second part (B) constitutes a panel (1b) partially separated from the first part (A) by cutouts that start along its lateral edges and are made by die cutting, this second part (B) having an open transverse cross section that is shaped by rolling so that it elastically matches the cross section of hole (C1) in the support (C).

2. Contact as claimed in claim 1 characterised in that panel (1b) has a cross section formed essentially in a shape obtained by rolling.

3. An assembly comprising contacts as claimed in claim 1 or 2 characterised in that it comprises an upper retention strip (B1) to which a plurality of contacts are joined by their respective first parts (A) and a lower retention strip (B2), panel (1b) of each of the contacts being connected to the lower retention strip by a chamfer (1c) extending as a straight strip (1d) of narrower width.
